# EUROPEAN PATENT APPLICATION

(11) **EP 1 211 728 A2**
(43) Date of publication of application: **05.06.2002**
(21) Application number: 01127426.3
(22) Date of filing: 26.11.2001
(51) Int. Cl.: H01L 21/768

(54) **Semiconductor device and method of manufacturing the same**

(30) Priority: 30.11.2000 JP 2000366358; 12.11.2001 JP 2001345725
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Shioya, Yoshimi, Minato-ku, Tokyo 108-0075 (JP); Ohira, Kouichi, Minato-ku, Tokyo 108-0075 (JP); Maeda, Kazuo, Minato-ku, Tokyo 108-0075 (JP); Suzuki, Tomomi, Minato-ku, Tokyo 108-0073 (JP); Yamamoto, Youichi, Minato-ku, Tokyo 108-0073 (JP); Kotake, Yuichiro, Minato-ku, Tokyo 108-0073 (JP); Ikakura, Hiroshi, Minato-ku, Tokyo 108-0073 (JP); Ohgawara, Shoji, Minato-ku, Tokyo 108-0073 (JP)
(74) Representative: Schwabe - Sandmair - Marx

(57) **Abstract**

A process gas containing any one of N₂ or N₂O is plasmanized and then a surface of a copper wiring layer (110) is exposed to the plasmanized process gas, whereby a surface layer portion of a copper wiring layer (110) is reformed and made into a copper diffusion preventing layer. According to this method, a noble semiconductor device can be provided, in which, along with increasing the operation speed, the copper diffusion is suppressed.

## Description

### BACKGROUND OF THE INVENTION

### 1. Field of the Invention

The present invention relates to a semiconductor device and a method of manufacturing the same and, more particularly, to the technology that is suitable for preventing the diffusion of the copper of the copper wiring layer.

### 2. Description of the Related Art

In recent years, in order to increase the operation speed of the semiconductor element such as LSI, etc., such a structure is gradually employed that the insulating film having the low dielectric constant (referred to as the "low dielectric constant film" hereinafter) is formed on the copper wiring layer as the interlayer insulating film. In this structure, the low dielectric constant film is formed on the copper wiring layer as an interlayer insulating film, and then the via hole is formed in this low dielectric constant film to expose the copper wiring layer. In forming this via hole, the block insulating film is formed on the copper wiring layer in advance, and then the interlayer insulating film is formed on this block insulating film. The block insulating film serves as an etching stopper film when etching the interlayer insulating film. The block insulating serves also as a copper diffusion preventing film, which prevents copper contained in the copper wiring layer from diffusing into the interlayer insulating film.

In the prior art, the silicon nitride film (referred to as the "SiN film" hereinafter), which is superior in preventing the copper diffusion, is used for the block insulating film.

SiN film, however, has a problem that it lowers the operation speed of the semiconductor device due to its high dielectric constant (about 7).

Other than the SiN film, some low dielectric constant films are known to be used for the block insulating film. These low dielectric constant films are formed using CVD method (Chemical Vapor Deposition method), and the reaction gases for this method is that consists of methylsilane (Si(CH₃)₄) and CH₄ or that consists of organic silane and CH₄. These methods, however, are problematic because a large number of Si-C bonds are formed in the low dielectric constant film. Since the Si-C bonds increases the leakage current in the film, the block film formed as above has the problem that the leakage current is large.

### SUMMARY OF THE INVENTION

It is an object of the present invention to provide a novel semiconductor device capable of preventing the diffusion of the copper in the copper wiring layer and a method of manufacturing the same.

According to the semiconductor device manufacturing method of the present invention, the process gas containing any one of N₂ and N₂O is plasmanized and then the surface of the copper wiring layer is exposed to the plasmanized process gas. Alternatively, the process gas containing N₂ and NH₃ may be plasmanized in place of above gas and then the surface of the copper wiring layer may be exposed to this plasmanized process gas.

According to the examination result, it was discovered that the surface layer portion of the copper wiring layer was reformed by these plasma processes and such surface layer portion could function as the copper diffusion preventing layer. This means that the copper wiring layer itself has the function of preventing the diffusion of copper. Therefore, the high ability of preventing copper diffusion is not required for the copper diffusion preventing film (the block insulating film, etc.) formed on the copper wiring layer, etc. Therefore, there is no need to use the high dielectric films (SiN film and like) of the prior art, which are considered to have a superior ability of preventing the copper diffusion.

Accordingly, in the present invention, films having relatively low dielectric constant can be formed on the copper wiring layer, in place of the high dielectric constant film in the prior art. Example of the films having the relatively low dielectric constant is the silicon- containing insulating film such as a SiOCH film, a SiO film, a SiONCH film, a SiCH film, a SiCNH film, and the like. If the high dielectric constant is not problematic, however, the SiN film may be employed.

The so-called damascene structure may be formed on this silicon-containing insulating film. In order to obtain the damascene structure, the interlayer insulating film is formed on the silicon-containing insulating film, then the via hole is formed in the silicon-containing insulating film and the interlayer insulating film, then the plug connected electrically to the copper wiring layer is buried in the via hole, and the upper wiring connected electrically to the plug is formed on the interlayer insulating film. As described above, since the surface layer portion of the copper wiring layer is reformed to function as the copper diffusion preventing layer, the diffusion of the copper into the silicon-containing insulating film and the interlayer insulating film can be prevented.

Moreover, if the surface of this copper wiring layer is exposed to the NH₃ plasma before the surface layer portion of the copper wiring layer is reformed, the natural oxide film formed on the surface of the copper wiring can be removed. If the natural oxide film is removed in this manner, the film formed on the copper wiring layer becomes difficult to peel off from the copper wiring layer.

Furthermore, instead of reforming the surface portion of the copper wiring in the above manner, a silicon-containing insulating film may be formed on the copper wiring layer which is not subjected to the above reforming process. In this case, after forming the silicon-containing insulating film, process gas containing at least one of NH₃, N₂, and N₂O is plasmanized and then the surface of the silicon- containing insulating film is exposed to the above plasmanized process gas. According to the examination result, it was discovered that the silicon-containing insulating film was reformed by this plasma process and the silicon-containing insulating film had the function as the copper diffusion preventing film.

As the silicon-containing insulating film to be reformed, there are a SiOCH film, a SiO film, a SiN film, a SiONCH film, a SiCH film, a SiCNH film, and the like, for example. Among these films, the SiOCH film and the SiONCH film can be formed by the chemical vapor deposition method using the reaction gas that contains a compound having a siloxane bonds. If the compound having the siloxane bonds is employed, the SiOCH film and the SiONCH film that have the low dielectric constant and suppress the leakage current can be formed. As a result, in the SiOCH film and in the SiONCH film, there exists no problem that the leakage current increases like in the prior art and that the operation speed of the semiconductor device slows due to the high dielectric constant like in the SiN film.

The so-called damascene structure may also be formed on the silicon-containing insulating film that is reformed in this manner. In order to obtain the damascene structure, the interlayer insulating film is formed on the reformed silicon-containing insulating film, then the via hole is formed in the silicon-containing insulating film and the interlayer insulating film, then the plug connected electrically to the copper wiring layer is buried in the via hole, and then the upper wiring connected electrically to the plug is formed on the interlayer insulating film. As described above, since the reformed silicon-containing insulating film can function as the copper diffusion preventing film, the copper can be prevented from diffusing into the silicon-containing insulating film and into the interlayer insulating film.

### BRIEF DESCRIPTION OF THE DRAWINGS

FIG.1 is a sectional view showing the semiconductor manufacturing equipment employed in an embodiment of the present invention;
FIGS.2A to 2C are sectional views showing steps of manufacturing a semiconductor device according to a first method of the embodiment of the present invention;
FIG.3 is a graph showing SIMS examination results about the elements that are contained in the silicon-containing insulating film immediately after the film formation, in the first method of the embodiment of the present invention;
FIG.4 is a graph showing SIMS examination results about the elements that are contained in the silicon-containing insulating film when such silicon-containing insulating film is annealed in vacuum at 500 °C for 4 hours, in the first method of the embodiment of the present invention;
FIG.5 is a graph showing SIMS examination results about the elements that are contained in the silicon-containing insulating film immediately after the film formation when the N₂ plasma process is not executed;
FIG.6 is a graph showing SIMS examination results about the elements that are contained in the silicon-containing insulating film which is not subjected to the N₂ plasma process when such silicon-containing insulating film is annealed in vacuum at 500 °C for 4 hours after the film formation;
FIGS.7A to 7C are sectional views showing steps of manufacturing a semiconductor device according to a second method of the embodiment of the present invention;
FIG.8 is a graph showing SIMS examination results about the elements that are contained in the silicon-containing insulating film when such silicon-containing insulating film is annealed in vacuum at 450 °C for 4 hours after the film formation, in the second method of the embodiment of the present invention;
FIG.9 is a sectional view showing a sectional structure used to measure the leakage current of the silicon- containing insulating film, in the second method of the embodiment of the present invention;
FIG.10 is a graph showing the leakage current of the silicon-containing insulating film when the NH₃ plasma process is performed for the silicon-containing insulating film immediately after the film formation, in the second method of the embodiment of the present invention;
FIG.11 is a graph showing the leakage current of the silicon-containing insulating film after such silicon-containing insulating film is subjected to the NH₃ plasma process and is then annealed, in the second method of the embodiment of the present invention; and
FIGS.12A to 12H are sectional views showing the case where the present invention is applied to the damascene method.

### DESCRIPTION OF THE PREFERRED EMBODIMENTS

Next, an embodiment of the present invention will be explained with reference to the accompanying drawings hereinafter.

### (1) Explanation of the semiconductor manufacturing equipment employed in the present embodiment

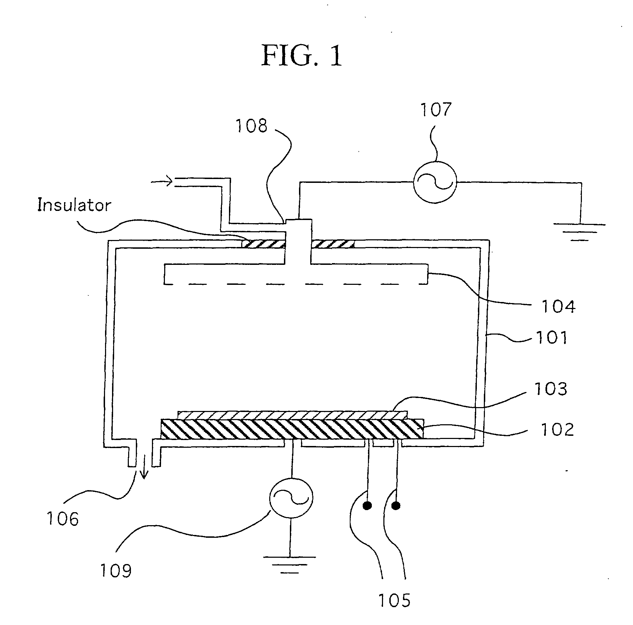

FIG.1 is a sectional view showing the semiconductor manufacturing equipment employed in the present embodiment.

In FIG.1, 101 denotes a chamber in which the film formation and the plasma process are carried out. Provided in the chamber 101 are two opposing electrodes, i.e., a lower electrode 102 and an upper electrode 104. The lower and upper electrodes 102, 104 both have an almost circular planar shape whose diameter is about 230 mm.

The lower electrode 102 is also used as a loading table on which a substrate 103 is loaded. A heater (not shown) for heating the substrate 103 up to a desired temperature is built in this lower electrode 102. In FIG.1, 105 denotes a power supplying wiring for supplying a power to this heater.

In addition, the upper electrode 104 is also used as a shower head for supplying a gas into the chamber 101.

A first high frequency power supply 107 and a second high frequency power supply 109 are connected to these two electrodes 104, 102 respectively. A gas in the chamber 101 can be plasmanized by supplying a high frequency power to the gas from one or both of these high frequency power supplies 107, 109.

A gas introducing port 108 is provided to the upper electrode 104, and the gas is introduced into the chamber 101 through the gas introducing port 108. An exhaust port 106 is provided to the chamber 101, and the gas introduced into the chamber 101 is exhausted via the port 106 to reduce the pressure in the chamber 101.

### (2) Explanation of a semiconductor device manufacturing method according to the embodiment of the present invention

Next, the semiconductor device manufacturing method according to the present embodiment will be explained hereunder. In order to manufacture the semiconductor device by the present embodiment, there are first and second methods described as follows.

### ① First method

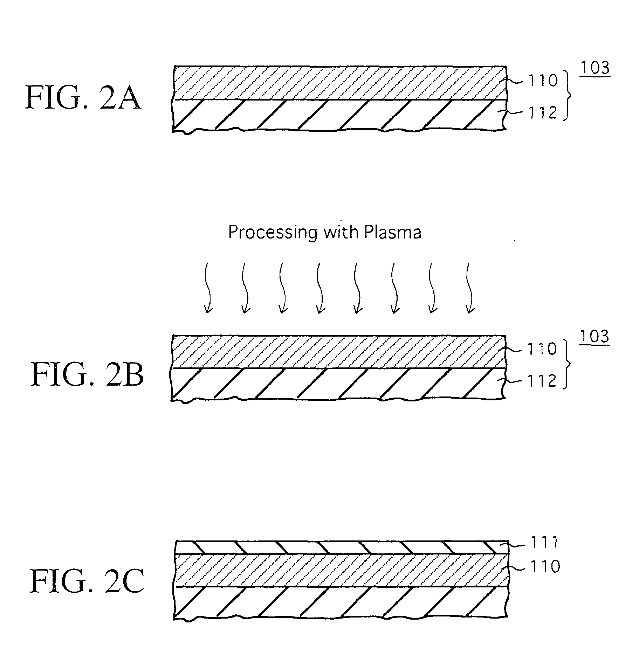

Firstly, the first method will be explained with reference to FIGS.2A to 2C hereunder.

In this method, as shown in FIG.2A, substrate 103 is loaded on the lower electrode 102 (see FIG.1). The substrate 103 is constructed by forming a copper wiring layer 110 on an underlying insulating film 112 such as SiO₂ film, or the like. The underlying insulating film 112 is formed on the silicon substrate (not shown).

Then, as shown in FIG.2B, a surface of the copper wiring layer 110 is processed with plasma and reformed. This process is carried out in accordance with following conditions A.

### (Conditions A)

· temperature of the substrate 103···375 °C
· pressure in the chamber 101···0.5 to 1.0 Torr
· frequency of the first high frequency power supply 107···13.56 MHz
· power of the first high frequency power supply 107···0 W (not applied)
· frequency of the second high frequency power supply 109···380 KHz
· power of the second high frequency power supply 109···150 W
· process time···30 sec
· process gas flow rate···see Table 1

**Table 1**

| Process gas | gas flow rate (sccm) | | | |
|---|---|---|---|---|
| | N₂ | N₂O | NH₃ | CₓH_{y} |
| ① N₂ | 100 | --- | --- | --- |
| ② N₂+N₂O | 200 | 100 | --- | --- |
| ③ N₂+NH₃ | 200 | --- | 100 | --- |
| ④ N₂+CₓH_{y} | 200 | --- | --- | 100 |
| ⑤ N₂O+CₓH_{y} | --- | 100 | --- | 200 |
| ⑥ N₂+N₂O+CₓH_{y} | 100 | 100 | --- | 100 |

As shown in Table 1, there are six types ① to ⑥ as the process gas. Any one of N₂ and N₂O is contained in all process gases. These gases are plasmanized in the chamber 101. In this case, NH₃ may be added as in the process gas ③, and CₓH_{y} (hydrocarbon) may be added as in the process gases ④ to ⑥. Specific examples of the CₓH_{y} are CH₄ and C₂H₂. It is postulated that if CₓH_{y} is added, a thin film made of CₓH_{y} is formed on the surface of the copper wiring layer 110. And it is expected that the copper wiring layer 110 is difficult to be etched in the later steps by this thin film.

Then, as shown in FIG.2C, a silicon-containing insulating film 111 is formed on the copper wiring layer 110. This silicon-containing insulating film 111 is formed by the plasma CVD method (Chemical Vapor Deposition method) in accordance with following conditions B.

### (Conditions B)

· temperature of the substrate 103··· 375 °C
· pressure in the chamber 101··· 1.0 Torr
· frequency of the first high frequency power supply 107··· 13.56 MHz
· power of the first high frequency power supply 107··· 0 W (not applied)
· frequency of the second high frequency power supply 109··· 380 KHz
· power of the second high frequency power supply 109··· 100 to 150 W
· deposited film thickness··· 100 nm
· gas flow rate ··· see Table 2

**Table 2**

| Type of silicon- Containing Insulating film 111 | gas flow rate (sccm) | | | | | |
|---|---|---|---|---|---|---|
| | HMDSO | TMS (Si(CH₃)₄) | SiH₄ | N₂O | NH₃ | CH₄ |
| ① SiOCH | 50 | --- | --- | --- | --- | 100 |
| ② SiO | --- | 50 | --- | 100 | --- | --- |
| ③ SiN | --- | --- | 50 | 100 | 100 | --- |
| ④ SiONCH | 50 | --- | --- | 200 | 100 | --- |
| ⑤ SiCH | --- | 50 | --- | --- | --- | 100 |
| ⑥ SiCNH | --- | 50 | --- | --- | 200 | 100 |

As shown in Table 2, there are an SiOCH film, an SiO film, an SiN film, an SiONCH film, an SiCH film, and an SiCNH film as the type of the silicon-containing insulating film 111 to be formed. These films can be formed by combining together the gases in Table 2. In the present invention, any one of these films may be employed. It should be noted that when the type of the film is denoted as "SiXYZ film", this film should be understood as containing at least an Si element, an X element, a Y element, and a Z element.

In Table 2, HMDSO (hexamethyldisiloxane: (Si(CH₃)₃)₂O) is liquid at the room temperature (20 °C). A flow rate of the liquid HMDSO is adjusted by the liquid massflow meter (not shown), and then the liquid HMDSO is vaporized by heating and then is introduced into the chamber 101. Alternatively, in place of this process, the liquid HMDSO may be vaporized, then the flow rate of the vaporized HMDSO may be adjusted by the high-temperature massflow meter (not shown), and then the vaporized HMDSO may be supplied to the chamber 101. The flow rate of the HMDSO in the conditions B is those obtained when the HMDSO is vaporized in the above manner.

In particular, the dielectric constant of the SiOCH film, which was formed by using the HMDSO under the conditions B, was about 4.0. This value is lower than the dielectric constant of the SiN film. Furthermore, if the HMDSO is used, since Si (silicon) in the HMDSO is already bonded to O (oxygen) in the form of siloxane bond (Si-O-Si), the Si-C bonds are not so much contained in the SiOCH film. As a result, the SiOCH film, dielectric constant thereof is low as explained above, becomes a film whose leakage current is suppressed. This is also the case for the SiONCH film that is formed by using the HMDSO.

The HMDSO is the compound having the siloxane bonds, but the similar advantage to the above can be obtained when any one of following compound having the siloxane bonds is employed in place of the HMDSO.
OMCTS (octamethylcyclotetrasiloxane : (Si(CH₃)₂)₄O₄)
HEDS (hexaethyldisiloxane : (Si(C₂H₅)₃)₂O)
TMDS (tetramethyldisiloxane : (SiH(CH₃)₂)₂O)
TEDS (tetraethyldisiloxane : (SiH(C₂H₅)₂)₂O)
TMCTS (tetramethylcyclotetrasiloxane : (SiH(CH₃))₄O₄)
TECTS (tetraethylcyclotetrasiloxane : (SiH(C₂H₅))₄O₄)

If any one of these compounds is employed, the silicon- containing insulating film 111 whose leakage current is suppressed and which has the low dielectric constant can be formed.

Also, as shown in Table 2, the organic silane (TMS (tetramethylsilane : Si(CH₃)₄)) is employed to form the SiO film, the SiCH film, and the SiCNH film, but other organic silane may be employed in place of TMS. As other organic silane, for example, there are trimethylsilane (SiH(CH₃)₃), dimethylsilane (SiH₂(CH₃)₂), and monomethylsilane (SiH₃(CH)).

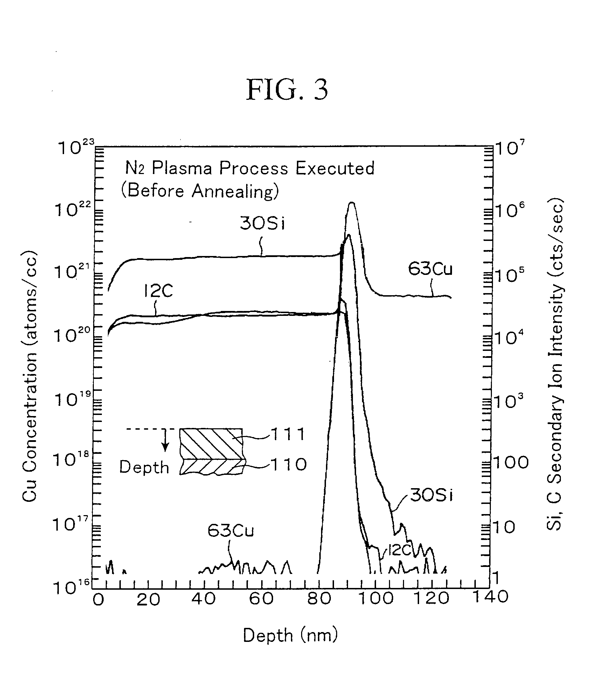

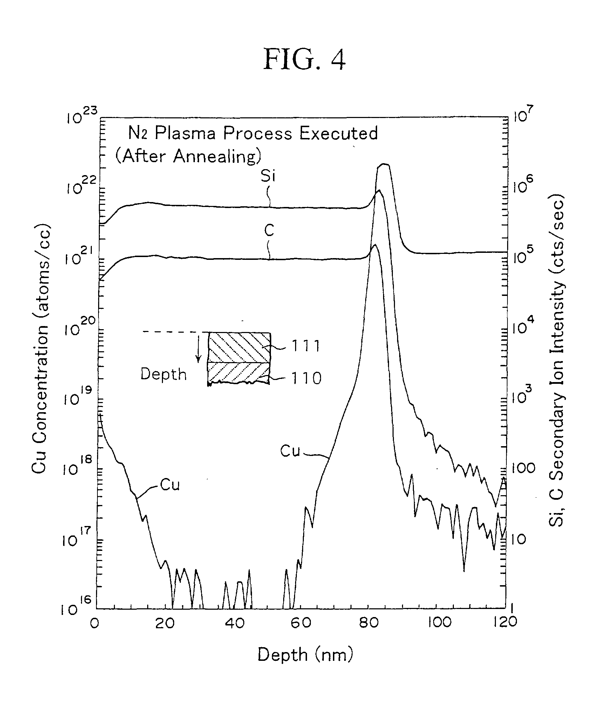

Then, examination results about the tendency of the copper diffusion from the copper wiring layer 110 to the silicon- containing insulating film 111 will be explained with reference to FIG.3 and FIG.4 hereunder. Particularly, explanation will be made for the case where N₂ (see ① in Table 1) is used as the process gas in the above conditions A, along with using the SiOCH film (see ① in Table 2) as the silicon- containing insulating film 111

FIG.3 is a graph showing results of examination, carried out by SIMS (Secondary-Ion-Mass- Spectroscopy), about the elements that are contained in the silicon-containing insulating film 111 immediately after the film was formed. In this examination, the relationships between a depth from the surface of the silicon-containing insulating film 111 and a Cu (copper) concentration at that depth were examined. An abscissa in FIG.3 denotes the depth (nm) from the surface of the insulating film 111 in a linear scale, and an ordinate on the left side denotes the Cu (copper) concentration (atoms/cc, i.e., the number of atoms per 1 cc) in a logarithmic scale. In this examination, secondary ion intensity (cts/sec) of Si (silicon) and C (carbon) contained in the film were also examined. An ordinate on the right side of the FIG.3 denotes the secondary ion intensity (cts/sec) of Si (silicon) and C (carbon) in a logarithmic scale.

In FIG.3, the numerical value affixed to the left side of the symbol of elements indicates the mass number of this element.

Also, FIG.4 is a graph showing SIMS examination results of the elements that were contained in the silicon-containing insulating film 111 after the silicon-containing insulating film 111 examined in FIG.3 was annealed in vacuum at 500 °C for 4 hours. This examination was carried out in the similar way to that in FIG.3.

Focusing on the copper concentration at the depth of 60 to 80 nm in FIG.4 reveals that gradient of the graph in this region is relatively steep, which indicate that copper diffusion from the copper wiring 110 into the insulating film 111 is little.

In addition, as shown in FIG.4, Cu (copper) contained in the silicon-containing insulating film 111 is very small in the middle range (the depth of about 20 to 60 nm) of the film. Practically, it is preferable that the number of Cu in the middle range of the film is less than 10¹⁷. It can be seen that the present method fulfills this condition.

Above arguments shows that the present invention can prevent the copper diffusion even when the anneal is performed.

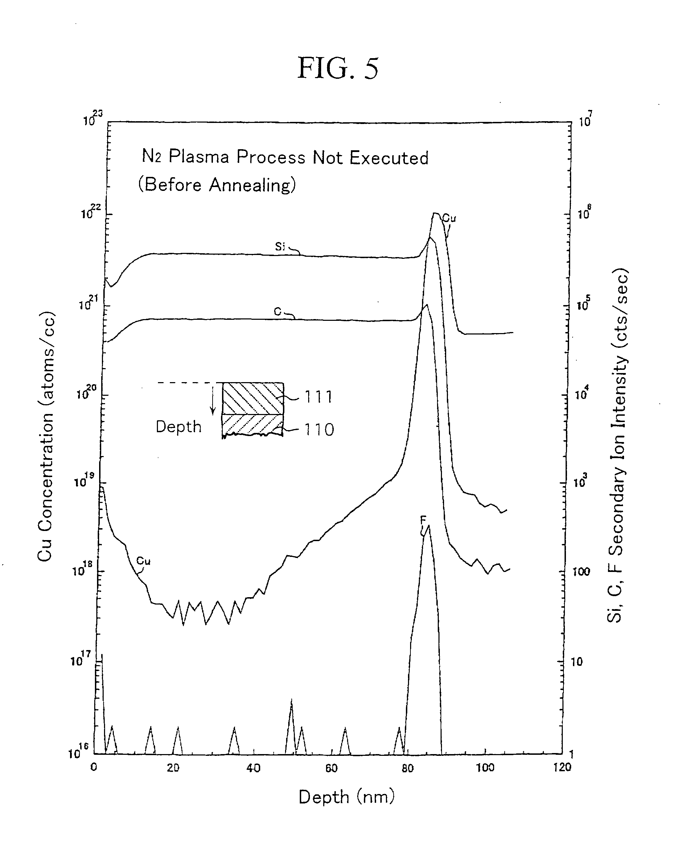

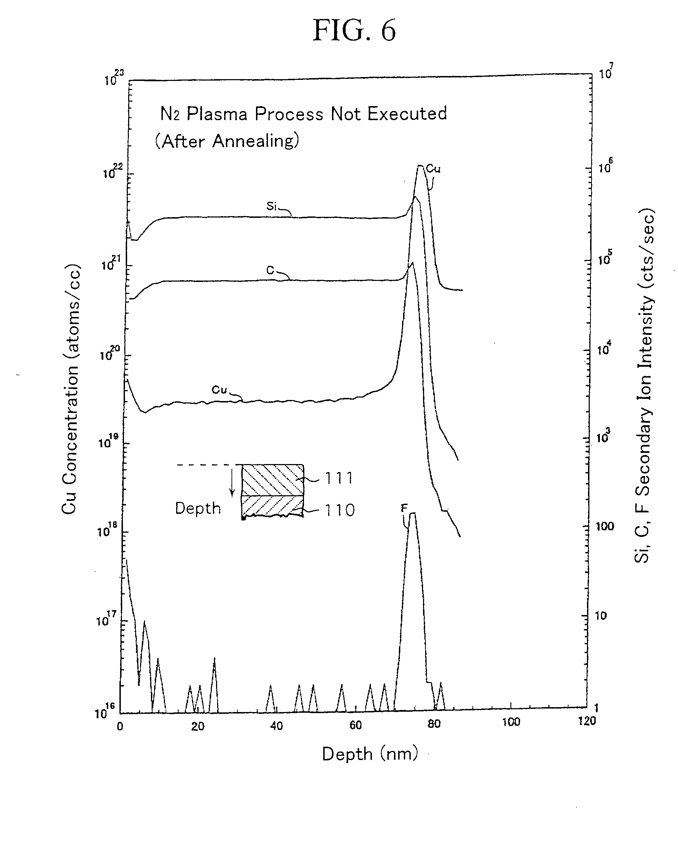

Next, in order to further confirm the effect of the N₂ plasma process, the explanation will be made for the case where the N₂ plasma process is not executed with reference to FIG.5 and FIG.6 hereunder. FIG.5 is a graph showing SIMS examination results, obtained immediately after the silicon- containing insulating film 111 was formed, about the elements that were contained in the silicon- containing insulating film 111 that was not subjected to the N₂ plasma process. This is just the case where the step shown in FIG.2C is executed, without executing the step in FIG.2B, directly after the step shown in FIG.2A is executed. Also, FIG.6 is a graph showing SIMS examination results about the elements that were contained in the insulating film 111 of the FIG.5, which were further subjected to an annealing in vacuum at 500 °C for 4 hours.

In FIG.5 and FIG.6, an abscissa denotes a depth (nm) from the surface of the insulating film 111 in a linear scale. Then, an ordinate on the left side denotes the Cu (copper) concentration (atoms/cc) in a logarithmic scale. Also, an ordinate on the right side denotes secondary ion intensity (cts/sec) of Si (silicon), C (carbon), and F (fluorine) in a logarithmic scale respectively.

As is apparent from comparing the Cu (copper) concentration of FIG.5 (before the annealing) and that of FIG.6 (after the annealing), it can be understood that the copper of the copper wiring layer 110 diffuses into the silicon-containing insulating film 111 by the annealing.

On the other hand, comparing the Cu (copper) of FIG.4 (performing the N₂ plasma process) and that of FIG.6 (not performing the N₂ plasma process) reveals the effect of the plasma process. That is, it can be understood that the Cu (copper) concentration in FIG.4 is lower than that in FIG.6.

According to the examination results shown in FIG.3 to FIG.6, it was verified that if the surface of the copper wiring layer 110 was exposed to the plasma under the conditions A, the surface layer portion of the copper wiring layer 110 was reformed to functions as the copper diffusion preventing layer. The inventors speculates that the surface layer portion of the copper wiring layer 110 would be nitrided by the plasma process and thus a thin film made of copper nitride would be formed on the surface layer portion, and this thin film would serve as the copper diffusion preventing layer.

This means that the copper wiring layer 110 itself have the function of preventing the copper diffusion. Therefore, according to the first method, there is no need to require the copper diffusion preventing film formed on the copper wiring layer 110 to have superior ability of preventing the copper diffusion. For this reason, there is no need in the first method to employ the high dielectric constant film such as the SiN film that is employed in the prior art due to its superior ability of preventing the copper diffusion.

### ② Second method

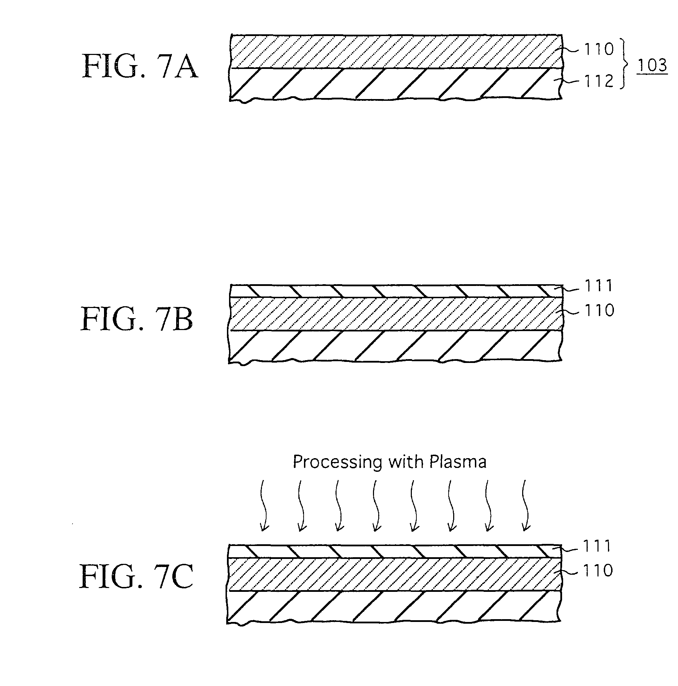

Next, the second method will be explained with reference to FIGS.7A to 7C hereunder.

In this method, as shown in FIG.7A, a substrate 103 is loaded on the lower electrode 102 (see FIG.1). The substrate 103 is constructed by forming the copper wiring layer 110 on the underlying insulating film 112. Although not shown, the underlying insulating film 112 is formed on a silicon substrate.

Then, as shown in FIG.7B, the silicon-containing insulating film 111 whose film thickness is 100 nm is formed on the copper wiring layer 110. This silicon-containing insulating film 111 is formed by the CVD method in accordance with the conditions B explained in the first method.

In turn, as shown in FIG.7C, the surface of the silicon- containing insulating film 111 is reformed by the plasma process in accordance with following conditions C.

### (Conditions C)

· temperature of the substrate 103···375 °C
· pressure in the chamber 101···0.5 to 6.0 Torr
· power of the first high frequency power supply 107···0 W (not applied)
· frequency of the second high frequency power supply 109···380 KHz
· power of the second high frequency power supply 109···150 W
· process time···30 sec
· process gas flow rate···see Table 3

**Table 3**

| Process gas | gas flow rate (sccm) |
|---|---|
| ① NH₃ | 100 to 300 |
| ② N₂ | 100 to 300 |
| ③ N₂O | 100 to 300 |

At least one of NH₃, N₂, and N₂O in Table 3 may be employed as the process gas.

Though only the second high frequency power supply 109 is employed under the conditions C, the first high frequency power supply 107 may be employed together with the second high frequency power supply 109. Alternatively, the first high frequency power supply 107 may be employed without employing the second high frequency power supply 109.

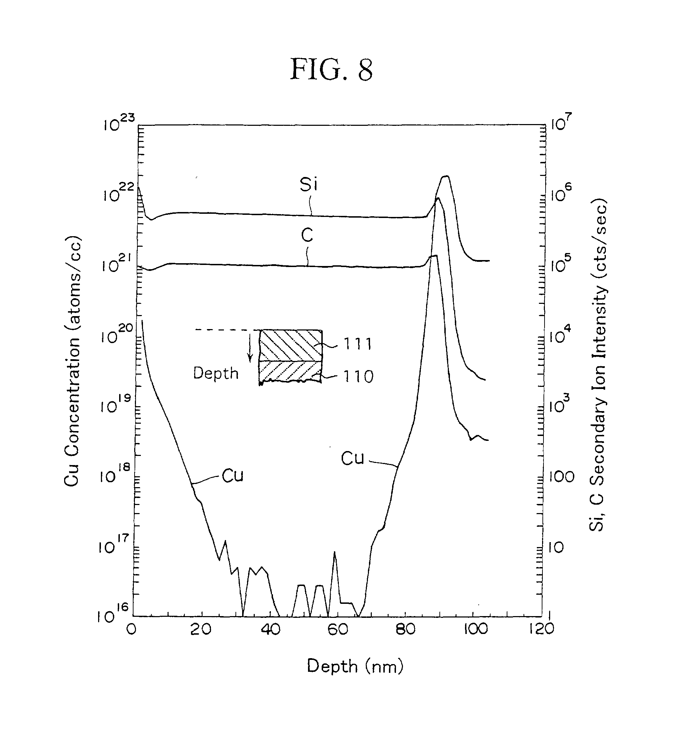

Next, examination results about the copper diffusion from the copper wiring layer 110 into the silicon-containing insulating film 111 will be explained with reference to FIG.8 hereunder. Particularly, the explanation will be made for the case where the SiOCH film (see ① in Table 2) is used as the silicon-containing insulating film 111, and NH₃ (see ① in Table 3) is used as the process gas in the conditions C.

FIG.8 is a graph showing SIMS examination results about the relationships between the depth (nm) from the surface of the silicon-containing insulating film 111 and the Cu (copper) concentration (atoms/cc) at that depth, when the insulating film 111 is annealed in vacuum at 450 °C for 4 hours after subjected to the NH₃ plasma process. In this examination, as in the first method, the relationships between the depth (nm) from the surface of the insulating film 111 and the secondary ion intensity (cts/sec) of Si (silicon) and C (carbon) at that depth were also examined. The SIMS examination method is similar to that in the first method.

As shown in FIG.8, the diffusion of Cu (copper) is little in this method. In addition, it can be understood from comparing FIG.6 (not executing the NH₃ plasma process) and FIG.8 (executing the NH₃ plasma process) that the Cu (copper) concentration in FIG.8 (executing the NH₃ plasma process is executed) is lower.

This means that exposing the surface of the silicon-containing insulating film 111 allows the film 111 to be reformed and to have a function of copper diffusion preventing film.

In this example, the SiOCH film is employed as the silicon-containing insulating film 111 and this film is formed by using the reaction gas containing the HMDSO (see the conditions B). Therefore, as has already been explained, not only the dielectric constant of the film can be lowered to about 4 but also the leakage current can be suppressed.

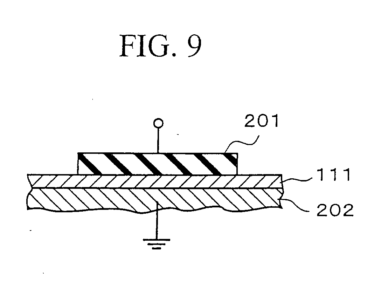

The inventors actually measured this leakage current. FIG.9 shows a sectional structure used to measure the leakage current. In FIG.9, 202 denotes a p-type silicon substrate that is grounded. Then, the silicon-containing insulating film 111 was formed on this p-type silicon substrate 202 under the conditions B. Also, 201 denotes a mercury probe used to apply the test voltage to the silicon-containing insulating film 111.

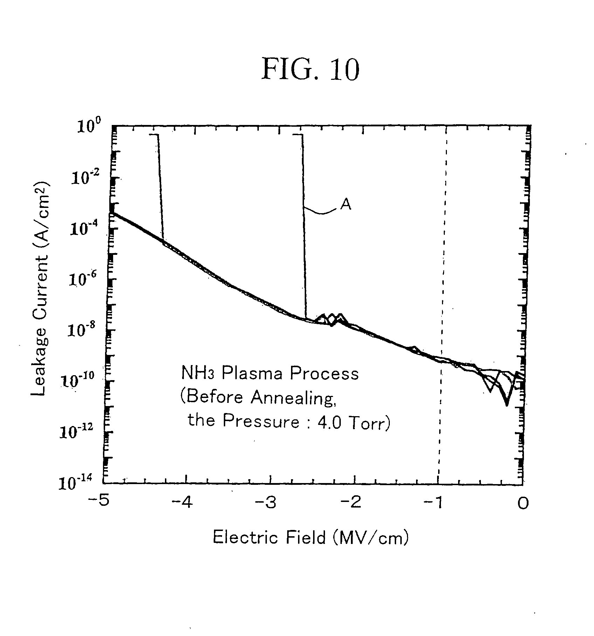

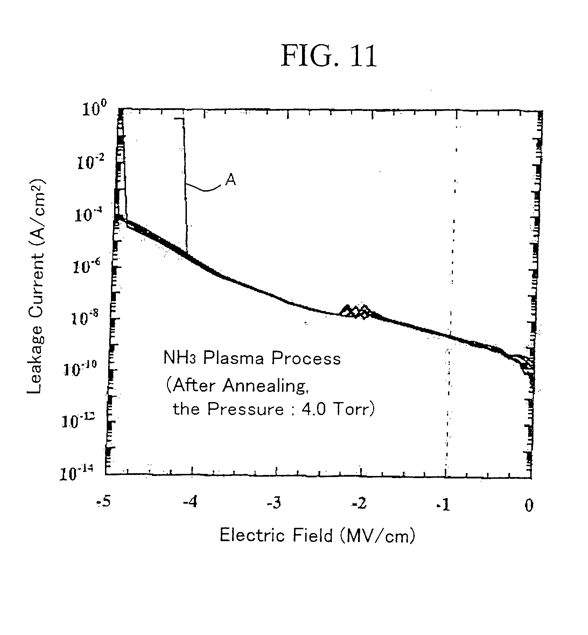

Measured results are shown in FIG.10 and FIG.11. In these figures, an abscissa denotes an electric field strength (MV/cm) applied to the mercury probe 201 (see FIG.9) in the measurement in a linear scale. A minus sign in the abscissa shows that the negative voltage is applied to the mercury probe 201. An ordinate denotes the leakage current (A/cm²) in a logarithmic scale.

FIG.10 is a graph showing the leakage current in the insulating film 111 when the NH₃ plasma process (under the conditions C) was performed for the insulating film 111 immediately after the insulating film 111 was formed.

On the other hand, FIG.11 is a graph showing the leakage current of the insulating film 111 after it was subjected to the NH₃ plasma process (under the conditions C) and was then annealed. The annealing was carried out in vacuum at 450 °C for 4 hours.

As is apparent from comparing FIG.10 and FIG.11, it is understood that the leakage current characteristic of the insulating film 111 that is subjected to the NH₃ plasma process is seldom changed before and after the annealing. Focusing on the curve A in FIG.10 and FIG.11 shows that the curve A shifts to the left side (higher electric field side) when the anneal is performed (FIG.11). Therefore, it can be expected that the leakage current characteristic can be improved by the annealing.

As described above, according to this method, the copper diffusion can be prevented by the silicon-containing insulating film 111 whose dielectric constant is lower than the prior art and in which the leakage current can be suppressed. Since the dielectric constant is lower than the prior art, insulating film 111 does not have a problem of lowering the operating speed of the semiconductor device as in the prior art.

It should be noted that the first and the second method may be executed independently as in the above or in combination thereof. Combining the first and the second method leads to the same advantage as in the above.

### ③ Explanation of the method of removing the natural oxide film on the surface of the copper wiring layer 110

The first and the second methods explained above may be executed after the natural oxide film on the surface of the copper wiring layer 110 is removed. This prevents the silicon-containing insulating film 111 from peeling off from the copper wiring layer 110. In order to remove the natural oxide film of the copper wiring layer 110 in the present embodiment, the surface of the copper wiring layer 110 is exposed to the NH₃ plasma. The NH₃ plasma process conditions are given in following conditions D.

### (Conditions D)

NH₃ flow rate···500 sccm
temperature of the substrate 103···375 °C
pressure in the chamber 101···6.0 Torr
frequency of the first high frequency power supply 107···13.56 MHz
power of the first high frequency power supply 107···400 W
power of the second high frequency power supply 109···0 W (not applied)
process time···10 sec

### (3) Explanation of application examples of the present invention

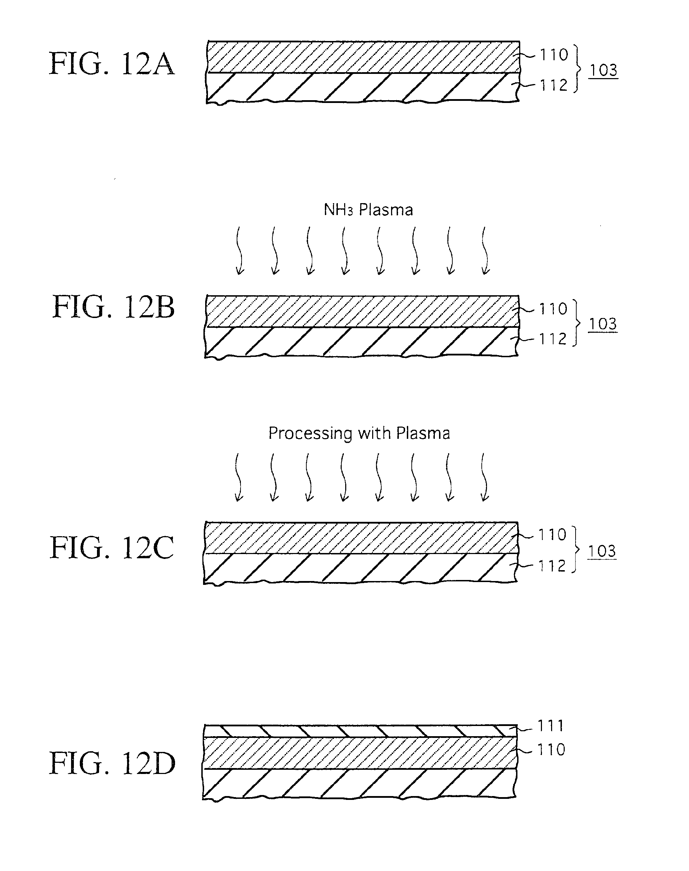

Next, application examples of the present invention will be explained hereunder. In the following, the present invention is applied to the damascene method that is useful for forming the copper wiring layer. FIGS.12A to 12H are sectional views showing the case where the present invention is applied to the damascene method.

Firstly, as shown in FIG.12A, the substrate 103 is prepared. This substrate 103 is constructed by forming the copper wiring layer (lower wiring) 110 on the underlying insulating film 112 such as the SiO₂ film, etc. Although not shown, the underlying insulating film 112 is formed on the silicon substrate.

Then, as shown in FIG.12B, in order to remove the natural oxide film on the surface of the copper wiring layer 110, the surface is exposed to the NH₃ plasma. The conditions for the NH₃ plasma process are given as the conditions D explained above.

Then, as shown in FIG.12C, the surface of the copper wiring layer 110, whose natural oxide film is removed, is processed by the plasma. The conditions for this plasma process are given as the conditions A explained in the above first method. The surface layer portion of the copper wiring layer 110 is reformed by this plasma process, and this surface layer portion functions as the copper diffusion preventing layer.

In turn, as shown in FIG.12D, the silicon-containing insulating film 111 is formed on the copper wiring layer 110. This silicon-containing insulating film 111 is formed under the conditions B explained above. Since the silicon-containing insulating film 111 functions as the block insulating film in the present application example, the insulating film 111 is called as the block insulating film 111 in the following. Also, because the natural oxide film of the copper wiring layer 110 is removed in the step shown in FIG.12B, the block insulating film 111 is made to be difficult to peel off from the copper wiring layer 110.

As explained in the above second method, after the block insulating film 111 is formed, the surface of the insulating film 111 may be exposed to the plasma in accordance with the above conditions C. In this case, the plasma process in FIG.12C may be omitted. Since the block insulating film 111 subjected to the plasma process has the function for preventing the diffusion of copper, there is no possibility that the copper diffuses into the interlayer insulating film to be formed on the insulating film 111 even if the plasma process in FIG.12C is omitted.

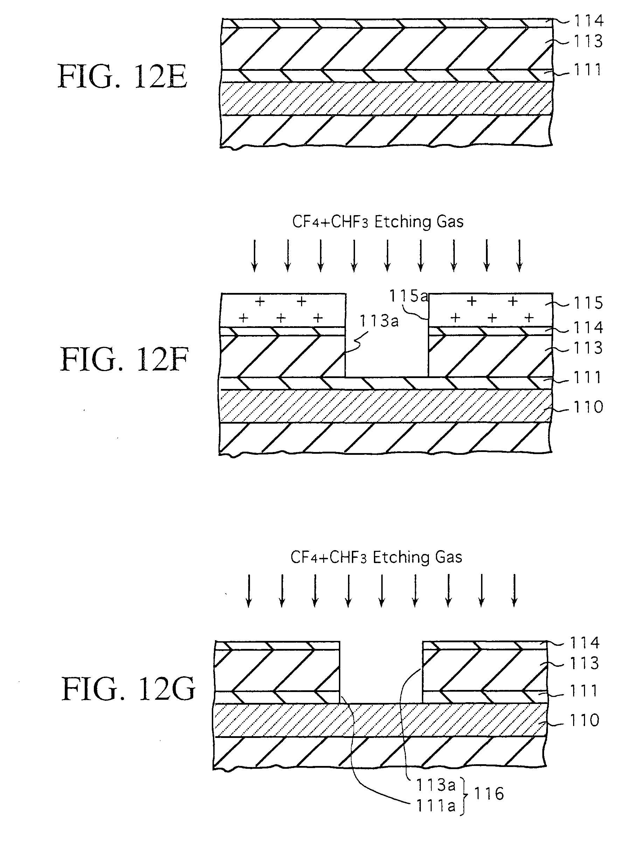

Then, as shown in FIG.12E, the interlayer insulating film 113 of low dielectric constant is formed on the block insulating film 111, and a protection film 114 is formed thereon. The interlayer insulating film 113 may be the well-known FSG (Fluorinated Silicon Oxide) or the porous SiO₂ film, for example. As the protection film 114, the NSG film (the silicon oxide film not containing the impurity) that has a thin thickness and a high density is employed. If the protection film 114 is absent, the quality of the interlayer insulating film 113 is altered by the process gas for ashing photoresist 115 (described later) or by etching gas for etching the block insulating film 111 which lies under the interlayer insulating film 113, which degrade the low dielectric constant characteristic of the insulating film 113. If, however, this is not problematic, the protection film 114 may be dispensed with.

Then, as shown in FIG.12F, the photoresist 115 is coated on the protection film 114, and then an opening portion 115a is formed in the photoresist 115 by the photolithography. Then, an opening portion 113a reaching the block insulating film 111 is formed by etching the interlayer insulating film 113 and the protection film 114 via the opening portion 115a by virtue of the reactive ion etching (RIE).

In this etching, gas mixture of CF₄+CHF₃ is employed as the etching gas, and the block insulating film 111 has the etching resistance against this etching gas. In other words, the block insulating film 111 functions as the etching stopper film for this etching.

Then, as shown in FIG.12G, after ashing and removing the photoresist 115, an opening portion 111a reaching the copper wiring layer 110 is formed by etching the block insulating film 111 via the opening portion 113a. This etching is carried out by the reactive ion etching (RIE). In this etching, gas mixture of the CF₄+CHF₃, which is employed in etching the interlayer insulating film 113 but whose composition ratio is changed, is employed as the etching gas. Since the copper wiring layer 110 has the etching resistance against this etching gas, the copper wiring layer 110 is not etched by this etching. According to this step, a via hole 116 defined by the opening portion 111a and 113a is formed.

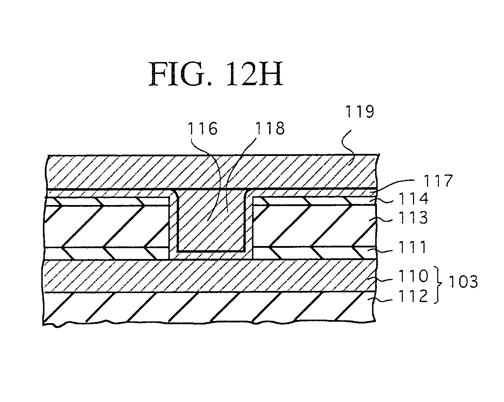

Then, as shown in FIG.12H, a seed layer 117 made of copper is formed on inner walls of the via hole 116 and on the protection film 114 by sputtering. After this, a first electrolytically copper-plated film 118 is formed on the seed layer 117 by supplying the electrical power to this seed layer 117. Then, the first electrolytically copper-plated film 118 that is formed higher than the via hole 116 is removed by the CMP method (Chemical Mechanical Polishing method). According to these steps, the structure, in which the plug formed of the first electrolytically copper-plated film 118 is buried in the via hole 116, can be obtained.

Finally, a second electrolytically copper-plated film (upper wiring) 119 is formed on the seed layer 117 and on the first electrolytically copper-plated film 118 by supplying the electrical power to the seed layer 117 once again.

Following the above steps leads to a structure, in which the copper wiring layer (lower wiring) 110 and the electrolytically copper-plated film (upper wiring) 119 are separated by the interlayer insulating film 113, but are electrically connected via the plug.

As is already explained, when the plasma process is performed for the surface of the copper wiring layer (lower wiring) 110 in accordance with the above conditions A, the surface layer portion of the copper wiring layer (lower wiring) 110 is reformed to act as the copper diffusion preventing layer. As a result, there is no need to employ the SiN film of the prior art, which has the high dielectric constant, as the block insulating film 111 formed on the copper wiring layer (lower wiring) 110. Instead, according to the present invention, films listed in Table 2 can be employed. Among these films, SiOCH film and the SiONCH film, both are formed using the HMDSO, suppress the leakage current and have a low dielectric constant (about 4.0). Therefore, present example can provide the semiconductor device having the high operation speed.

To summarize, according to the semiconductor device manufacturing method of the present invention, the process gas containing any one of N₂ and N₂O is plasmanized and then the surface of the copper wiring layer is exposed to the plasmanized process gas. Alternatively, the process gas containing N₂ and NH₃ is plasmanized in place of this gas and then the surface of the copper wiring layer is exposed to the plasmanized process gas. By these plasma processes, the surface layer portion of the copper wiring layer can be reformed and made into the copper diffusion preventing layer. According to this, since the copper wiring layer itself has the function of preventing the copper diffusion, the superior ability of preventing copper diffusion is not required for the copper diffusion preventing film, such as the block insulating film and the like, which is formed on the copper wiring layer. Therefore, there is no need to use high dielectric constant films, such as SiN film, which are used in the prior art due to its superior ability of preventing the copper diffusion.

Then, if the surface of this copper wiring layer is exposed to the NH₃ plasma before the surface layer portion of the copper wiring layer is reformed, the natural oxide film formed on the surface of the copper wiring can be removed.

Also, instead of reforming the surface of the copper wiring layer as above, the silicon-containing insulating film may be formed on the copper wiring layer, and then the process gas containing at least one of NH₃, N₂, and N₂O is plasmanized, and then the surface of the silicon-containing insulating film may be exposed to the plasmanized process gas. According to this, the silicon-containing insulating film is reformed to act as the copper diffusion preventing film.

In this case, if the silicon-containing insulating film is formed by the chemical vapor deposition method using the reaction gas that contains the compound having the siloxane bonds, such silicon-containing insulating film can have low dielectric constant and can suppress the leakage current. As a result, this silicon-containing insulating film does not have a problem that the leakage current increases as in the prior art and that the operation speed of the semiconductor device is slowed due to the high dielectric constant as in the SiN film.

Although the invention has been described with reference to specific embodiments, these descriptions are not meant to be constructed in a limiting sense. Various modifications of the disclosed embodiments, as well as alternative embodiments of the invention will become apparent to persons skilled in the art upon reference to the description of the invention. It should be appreciated by those skilled in the art that the conception and the specific embodiment disclosed may be readily utilized as a basis for modifying or designing other structures for carrying out the same purposes of the present invention. It should also be realized by those skilled in the art that such equivalent constructions do not depart form the spirit and scope of the invention as set forth in the appended claims.

It is therefore contemplated that the claims will cover any such modifications or embodiments that fall within the true scope of the inventions.

## Claims

1. A semiconductor device manufacturing method comprising the step of:
plasmanizing a process gas containing any one of N₂ and N₂O; and
reforming a surface layer portion of a copper wiring layer (110) to make the surface layer portion into a copper diffusion preventing layer by exposing a surface of the copper wiring layer (110) to the plasmanized process gas.

2. A semiconductor device manufacturing method according to claim 1, wherein a hydrocarbon is added to the process gas.

3. A semiconductor device manufacturing method according to claim 2, wherein the hydrocarbon is any of CH₄ and C₂H₂.

4. A semiconductor device manufacturing method comprising the step of:
plasmanizing a process gas containing N₂ and NH₃; and
reforming a surface layer portion of a copper wiring layer (110) to make the surface layer portion into a copper diffusion preventing layer by exposing a surface of the copper wiring layer (110) to the plasmanized process gas.

5. A semiconductor device manufacturing method according to any one of claims 1 to 4 further comprising the step of:
exposing the surface of the copper wiring layer (110) to a NH₃ plasma before the surface layer portion of the copper wiring layer (110) is reformed.

6. A semiconductor device manufacturing method according to any one of claims 1 to 5, further comprising the step of:
forming a silicon- containing insulating film (111) on the copper wiring layer (110) after the surface layer portion of the copper wiring layer (110) is reformed.

7. A semiconductor device manufacturing method according to claim 6, further comprising the step of:
plasmanizing a process gas containing at least one of NH₃, N₂, and N₂O; and
after forming the silicon-containing insulating film (111), exposing the silicon-containing insulating film (111) to the plasmanized process gas.

8. A semiconductor device manufacturing method according to claim 6, further comprising the step of:
forming an interlayer insulating film (113) on the silicon- containing insulating film (111);
forming a via hole (116) in the silicon-containing insulating film (111) and the interlayer insulating film (113);
burying a plug (118) connected electrically to the copper wiring layer (110) in the via hole (116); and
forming an upper wiring (119) connected electrically to the plug (118) on the interlayer insulating film (113).

9. A semiconductor device manufacturing method comprising the steps of:
forming a silicon-containing insulating film (111) on a copper wiring layer (110);
plasmanizing a process gas containing at least one of NH₃, N₂ and N₂O; and
reforming the silicon-containing insulating film (111) by exposing the silicon-containing insulating film (111) to the plasmanized process gas.

10. A semiconductor device manufacturing method according to claim 9, further comprising the step of:
exposing a surface of the copper wiring layer (110) to a NH₃ plasma before the silicon- containing insulating film (111) is formed.

11. A semiconductor device manufacturing method according to claim 9 or claim 10, further comprising the step of:
forming an interlayer insulating film (113) on the silicon- containing insulating film (111) after the silicon containing insulating film (111) is reformed;
forming a via hole (116) in the silicon-containing insulating film (111) and the interlayer insulating film (113);
burying a plug (118) connected electrically to the copper wiring layer (110) in the via hole (116); and
forming an upper wiring (119) connected electrically to the plug (118) on the interlayer insulating film (113).

12. A semiconductor device manufacturing method according to claim 8 or claim 11, wherein the interlayer insulating film (113) is any one of an FSG film and a porous SiO₂ film.

13. A semiconductor device manufacturing method according to any one of claims 6 to 12, wherein the silicon-containing insulating film (111) is any one selected from the group consisting of an SiOCH film, an SiO film, an SiN film, an SiONCH film, an SiCH film, and an SiCNH film.

14. A semiconductor device manufacturing method according to claim 13, wherein the SiOCH film is formed by a chemical vapor deposition method using a reaction gas containing a compound having siloxane bonds.

15. A semiconductor device manufacturing method according to claim 13, wherein the SiONCH film is formed by a chemical vapor deposition method using a reaction gas containing a compound having siloxane bonds and N₂O.

16. A semiconductor device manufacturing method according to claim 14 or claim 15, wherein the compound having the siloxane bonds is any one selected from the group consisting of HMDSO ((Si(CH₃)₃)₂O), OMCTS ((Si(CH₃)₂)₄O₄), HEDS ((Si(C₂H₅)₃)₂O), TMDS ((SiH(CH₃)₂)₂O), TEDS ((SiH(C₂H₅)₂)₂O), TMCTS ((SiH(CH₃))₄O₄), and TECTS ((SiH(C₂H₅))₄O₄).

17. A semiconductor device manufacturing method according to claim 13, wherein the SiN film is formed by a chemical vapor deposition method using a reaction gas containing SiH₄ and N₂O.

18. A semiconductor device manufacturing method according to claim 17, wherein NH₃ is added to the reaction gas.

19. A semiconductor device manufacturing method according to claim 13, wherein the SiO film is formed by a chemical vapor deposition method using a reaction gas containing organic silane.

20. A semiconductor device manufacturing method according to claim 13, wherein the SiCH film is formed by a chemical vapor deposition method using a reaction gas containing organic silane and hydrocarbon.

21. A semiconductor device manufacturing method according to claim 13, wherein the SiCNH film is formed by a chemical vapor deposition method using a reaction gas containing NH₃, organic silane, and hydrocarbon.

22. A semiconductor device manufacturing method according to any one of claims 19 to 21, wherein the organic silane is TMS(Si(CH₃)₄).

23. A semiconductor device manufacturing method according to claim 20 or claim 21, wherein the hydrocarbon is CH₄ or C₂H₂.

24. A semiconductor device manufactured by the semiconductor device manufacturing method set forth in any one of claims 1 to 23.
